# FASCICULE DE BREVET EUROPEEN

(11) **EP 0 544 566 B1**
(45) Date de publication et mention de la délivrance du brevet: **14.05.1997**
(21) Numéro de dépôt: 92403112.3
(22) Date de dépôt: 19.11.1992
(51) Int. Cl.: G01R 31/36, G01R 19/165

(54) **Module contrôleur d'alimentation pour ensemble de contrôle de batterie d'un appareil et batterie équipée d'un tel module**
Stromquellenkontrollmodul für Batteriekontrolleinheit und Batterie mit diesem Modul
Source monitoring module for battery monitoring unit and battery equipped with the same

(30) Priorité: 25.11.1991 FR 9114494
(43) Date de publication de la demande: 02.06.1993
(73) Titulaire: SAFT, F-93230 Romainville (FR)
(72) Inventeur: Perelle, Michel, F-37210 Parcay Meslay (FR)
(74) Mandataire: Schaub, Bernard

(56) Documents cités:
- EP-A- 0 448 767
- DE-A- 3 832 840
- DE-A- 4 103 470
- FR-A- 2 645 352
- US-A- 3 900 785

## Description

L'invention concerne un module contrôleur d'alimentation pour ensemble de contrôle d'une batterie d'un appareil susceptible d'être ainsi alimenté, ainsi que les batteries équipées de tels modules, en particulier celles de type lithium.

L'alimentation en énergie de nombreux appareils électriques, notamment autonomes ou portables, est susceptible d'être réalisée par des batteries dont les constituants chimiques sont différents, mais qui sont agencés pour se loger dans les mêmes réceptacles des appareils à alimenter de manière à être pratiquement interchangeables.

Ces batteries bien qu'interchangeables ne possèdent pas exactement les mêmes caractéristiques électriques en particulier en matière de charge et de décharge.

Or il est bien connu d'assurer une surveillance d'une alimentation assurée par batterie à l'aide d'un ensemble de contrôle comprenant un appareillage et/ou un circuit permettant au minimum de mesurer au moins l'un des paramètres de la batterie, telle que la tension à ses bornes et/ou éventuellement d'assurer le contrôle de sa recharge et/ou de sa mise hors service.

Ainsi le document US-A-3900785 décrit un ensemble de contrôle de courant de charge pour batterie d'accumulateur qui comporte un circuit détecteur incorporant un shunt qui est monté en série avec la batterie et qui est relié par ses bornes aux entrées d'un premier amplificateur opérationnel monté en comparateur pour consommer peu et exploité en détecteur de courant. Les documents DE-A-4103470, DE-A 3832840 et EP-A-0448767 décrivent respectivement des ensembles de contrôle pour batterie qui comportent aussi des circuits détecteurs incorporant des amplificateurs opérationnels de surveillance exploités pour déterminer au moins une caractéristique relative aux possibilités d'exploitation des batteries auxquelles ils sont respectivement susceptibles d'être associés.

Un ensemble de contrôle de ce genre n'est généralement pas apte à reconnaître les caractéristiques du type de batterie auquel il est relié.

Or une alimentation insuffisamment performante peut présenter de graves inconvénients pour l'utilisateur, en particulier si elle conduit à un fonctionnement incorrect et/ou sporadique de l'appareillage ou de son ensemble de contrôle; de plus dans certains cas une détérioration de la batterie est susceptible d'en résulter.

L'invention propose donc un module contrôleur d'alimentation, pour ensemble de contrôle d'une batterie d'alimentation d'un appareil comportant un circuit détecteur, associé à un circuit interrupteur placé dans la boucle d'alimentation de l'appareil par la batterie, ce circuit détecteur comportant un shunt inséré dans la boucle d'alimentation de l'appareil entre la batterie et le circuit interrupteur ce shunt étant relié par ses bornes aux entrées d'un premier amplificateur opérationnel qui est monté en comparateur pour consommer peu et exploité en détecteur de courant pour ne fournir un courant de sortie qu'en présence dans le shunt d'un courant d'utilisation de batterie supérieur à une première valeur déterminée.

Selon une caractéristique de l'invention, le circuit détecteur comporte aussi un second circuit amplificateur, monté en comparateur pour consommer peu et exploité en détecteur de courant, dont les entrées sont reliées d'une part aux bornes du shunt, d'autre part, via ce shunt, aux bornes d'une diode placée en série avec une résistance de calibrage dans une branche parallèle au circuit interrupteur, pour ne fournir un courant de sortie qu'en présence soit dans le shunt d'un courant de charge rapide de batterie qui traverse le circuit interrupteur et qui est supérieur à une seconde valeur déterminée, soit aux bornes de la diode d'une tension correspondant à une valeur de courant de charge d'entretien supérieure à une troisième valeur déterminée, elle-même très inférieure à la seconde valeur prédéterminée.

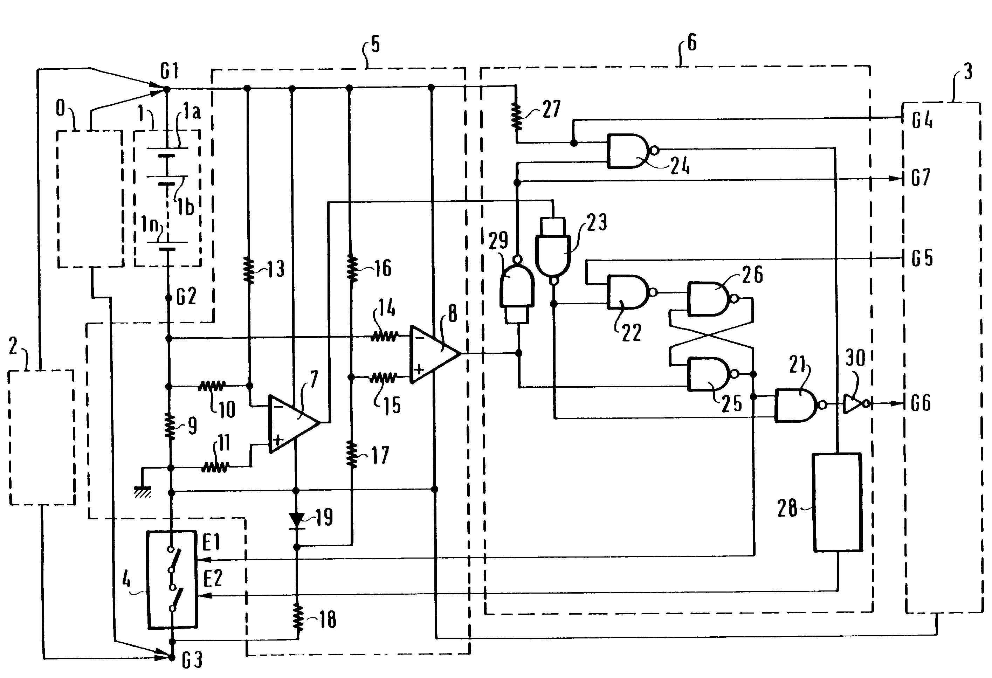

L'invention, ses caractéristiques et ses avantages sont précisés dans la description qui suit, en liaison avec la figure définie ci-dessous.

Cette figure unique présente un schéma d'une alimentation par batterie pour appareil électrique comportant un module contrôleur d'alimentation, selon l'invention.

Ce module contrôleur d'alimentation est destiné à être associé à une batterie 1 composée d'au moins un et le plus souvent de plusieurs éléments accumulateurs, ici référencés 1a, 1b,..., 1n.

Cette batterie 1 est destinée à alimenter un appareil électrique 2, supervisé par un ensemble de contrôle, organisé par exemple autour d'un microprocesseur de manière classique non détaillée ici, cet ensemble de contrôle est susceptible de comporter divers modules spécialisés, référencés en tant que sous-ensemble 3 et non développés ici car sans rapport direct avec l'invention, ainsi qu'un module contrôleur d'alimentation objet de l'invention.

Le module contrôleur d'alimentation de batterie est ici composé d'un circuit interrupteur 4, d'un circuit détecteur 5 et d'un circuit logique d'interface 6 reliant le circuit détecteur au circuit interrupteur et à l'ensemble de contrôle.

La batterie 1 comporte deux bornes d'extrémité G1 et G2, l'une positive et l'autre négative, par l'intermédiaire desquelles elle est susceptible d'alimenter, d'une part, l'appareil 2, d'autre part, les circuits 4, 5, 6 et au moins une partie des modules de l'ensemble de contrôle.

Elle est éventuellement rechargeable par l'intermédiaire d'un chargeur 0 qui assure par exemple une recharge individuelle rapide des éléments accumulateurs 1a à 1n.

Le chargeur 0 et l'appareil électrique 2 ne seront pas détaillés dans la mesure où ils appartiennent à des catégories de matériels bien connus de l'homme de métier et où leur structures internes respectives n'ont pas de rapport direct avec l'invention.

Le circuit interrupteur 4 est un classique montage électronique qui s'insère en série dans la boucle d'alimentation de l'appareil 2 par la batterie 1, soit ici entre la borne G2 de batterie et une borne G3 d'alimentation, l'alimentation de l'appareil et la charge de la batterie par le chargeur s'effectuant en fait entre bornes G1 et G3. Ce circuit interrupteur 4 comporte au moins une et ici deux entrées de commande E1 et E2, dont les actions respectives entraînent l'interruption d'une liaison conductrice interne autrement établie entre les bornes G2 et G3.

Dans une forme préférée de réalisation, le circuit interrupteur 4 est prévu pour être physiquement associé à la batterie, avec les circuits 5 et 6, par exemple en un module incorporé dans le conditionnement individuel habillant un élément accumulateur destiné à être utilisé seul ou dans le conditionnement commun à l'ensemble des éléments accumulateurs d'une batterie.

Le circuit détecteur 5 est organisé autour de deux amplificateurs opérationnels 7, 8 et d'un shunt 9.

Le shunt 9 est monté en série entre le circuit interrupteur 4 et la borne de batterie G2, il est parcouru par le courant provenant de cette batterie, lorsque la liaison conductrice interne du circuit interrupteur est passante.

Les amplificateurs opérationnels sont similairement montés en comparateurs et respectivement destinés à agir l'un en cas d'utilisation de la batterie en source d'alimentation et l'autre en cas de charge, rapide ou d'entretien, de batterie; l'appareil n'est alors pas susceptible d'être alimenté.

L'amplificateur opérationnel 7 est relié aux bornes du shunt 9, via deux résistances 10 et 11 respectivement reliées l'une à son entrée inverseuse et l'autre à son entrée non-inverseuse.

Une forte résistance de régulation 13 relie également l'entrée inverseuse de cet amplificateur opérationnel 7 à la borne positive G1, elle coopère avec la résistance 10 pour la fixation par cette dernière du seuil de basculement du montage comparateur, en phase d'utilisation de l'appareil 2.

L'amplificateur 8 est actif en cas de charge, il possède une entrée inverseuse qui est reliée par une résistance 14 à la borne G2, et une entrée non-inverseuse qui est reliée par une résistance 15 au point commun aux résistances 16, 17 d'un pont diviseur relié par une extrémité et via la résistance 16 à la borne G1 et par l'autre extrémité, à la borne G3, via la résistance 17 et une résistance de calibrage 18 en série, la résistance 17 coopère avec la résistance pour la fixation du seuil de basculement du montage comparateur correspondant en phase de charge rapide.

Une diode 19, éventuellement électroluminescente, est insérée en série avec la résistance 18 en une branche parallèle au circuit interrupteur 4, elle est reliée d'une part par sa cathode à la borne G2, via le shunt 9, de même que les entrées d'alimentation négative des amplificateurs 7, 8 et de l'ensemble de contrôle 3, et d'autre part par son anode à la borne G3, via la résistance 18.

Elle permet à l'amplificateur opérationnel 8 de détecter la présence d'un courant de charge d'entretien insuffisant pour être détecté au niveau du shunt 9, vu sa relativement faible intensité vis à vis des courants de charge rapide et de décharge.

Le circuit d'interface 6 est relié aux sorties des amplificateurs opérationnels 7 et 8.

Le signal de sortie de l'amplificateur opérationnel 7 est appliqué à une première entrée de deux portes 21 et 22, de type NAND, via un inverseur 23, alors que celui fourni par l'amplificateur opérationnel 8 est appliqué à une première entrée de deux portes 24 et 25 de type NAND, via un inverseur 29 pour la porte 24.

Une seconde entrée de chacune des portes 22 et 24 reçoit un signal en provenance de l'ensemble de contrôle 3, via respectivement une borne référencée G5 pour la porte 22 et une borne G4 pour la porte 24, qui est par ailleurs reliée à la borne G1 par une forte résistance 27.

Une porte 26, de type NAND, complète ce montage de portes, elle est reliée par une première entrée à la sortie de la porte 22 et par une seconde entrée en sortie de la porte 25, cette dernière ayant elle-même sa seconde entrée reliée en sortie de la porte 26 selon un montage classique.

L'inverseur 23 permet d'alimenter par l'intermédiaire des portes 21, 30 en série et soit directement, soit via le montage à portes 22, 25, 26, les éléments constitutifs non représentés de l'ensemble de contrôle 3, qui sont actifs en phase d'utilisation de la batterie pour l'alimentation de l'appareil.

Cet inverseur 23 contrôle aussi l'établissement de la liaison conductrice interne du circuit interrupteur 4 entre bornes G2 et G3, via une entrée de commande E1 de ce circuit et suivant les niveaux respectifs du signal de sortie de l'amplificateur 7 et du signal correspondant fourni à la porte 22 du montage à portes 22, 25, 26 par l'ensemble de contrôle 3, via une borne référencée G5.

L'inverseur 29 permet d'alimenter les éléments constitutifs non représentés de l'ensemble de contrôle 3, qui sont actifs en phase de charge de la batterie.

Cet inverseur 29 contrôle aussi le montage de commande 28 du circuit interrupteur 4, en liaison avec la porte 24, elle agit ainsi sur l'entrée E2 de ce circuit de sorte que la liaison conductrice interne de ce dernier soit établie passante, si la batterie est indiquée en charge rapide, et soit interrompue, si c'est une indication de charge d'entretien qui est obtenue.

Le montage de commande 28 est par exemple organisé autour d'un multivibrateur non représenté.

Lorsque la batterie 1 équipée du module contrôleur d'alimentation est laissée seule, par exemple en stockage, sans être connectée ni à un appareil 2 et à la logique de contrôle associée, ni à un chargeur 0, la liaison conductrice interne du circuit interrupteur 4 est interrompue et la seule consommation effective est pratiquement celle des amplificateurs opérationnels 7 et 8 et des résistances associées à eux.

Cette consommation est négligeable si les amplificateurs sont exploités en comparateurs et ont une très faible consommation unitaire en raison de leur technologie, par exemple de type C-MOS.

Si la batterie 1 est en phase de charge rapide, un fort courant traverse le shunt 9 et agit sur l'amplificateur opérationnel 8, les éléments constitutifs, actifs en phase de charge, des modules du sous-ensemble de commande 3 sont alimentés et le circuit interrupteur 4 est alors passant.

Si la batterie 1 est en phase de charge d'entretien, c'est la tension aux bornes de la diode 19 qui est prise en compte par l'amplificateur opérationnel 8, puisqu'il n'y a pas un courant suffisant au travers du shunt 9 et que pour cette raison le circuit interrupteur 4 est commandé non passant.

En phase d'utilisation de la batterie 1 pour l'alimentation de l'appareil 2, l'amplificateur opérationnel 7 alimente les éléments constitutifs, actifs en phase d'utilisation, du sous-ensemble de commande 3 et maintient passant le circuit interrupteur 4, en l'absence de défaut, tel qu'une surintensité ou un e décharge profonde, en cours de décharge de la batterie, ce défaut étant alors indiqué au circuit 6, via la borne G5.

Dans la mesure où au moins le circuit détecteur 5 d'un module contrôleur d'alimentation est associé de manière permanente à une batterie d'un type donné en étant, par exemple, incorporé dans le conditionnement habillant cette batterie, avec éventuellement les deux autres circuits, il n' y a pas de difficulté à toujours disposer d'un module qui, spécifiquement adapté aux caractéristiques spécifiques de ce type de batterie, est susceptible d'attaquer dans des conditions standardisées, pour différents types de batterie interchangeables, les éléments constitutifs restants d'un ensemble de contrôle de batterie.

## Revendications

1. Module contrôleur d'alimentation, pour ensemble de contrôle d'une batterie d'alimentation (1) d'un appareil (2) comportant un circuit détecteur (5), associé à un circuit interrupteur (4) placé dans la boucle d'alimentation de l'appareil par la batterie, ce circuit détecteur comportant un shunt (9) inséré dans la boucle d'alimentation de l'appareil entre la batterie et le circuit interrupteur ce shunt étant relié par ses bornes aux entrées (+,-) d'un premier amplificateur opérationnel (7) qui est monté en comparateur pour consommer peu et exploité en détecteur de courant pour ne fournir un courant de sortie qu'en présence dans le shunt d'un courant d'utilisation de batterie supérieur à une première valeur déterminée, caractérisé en ce que ledit circuit détecteur comporte de plus un second circuit amplificateur (8), monté en comparateur pour consommer peu et exploité en détecteur de courant, dont les entrées (+,-) sont reliées d'une part aux bornes du shunt, d'autre part, via ce shunt, aux bornes d'une diode (19) placée en série avec une résistance de calibrage (18) dans une branche parallèle au circuit interrupteur, pour ne fournir un courant de sortie qu'en présence soit dans le shunt d'un courant de charge rapide de batterie qui traverse le circuit interrupteur et qui est supérieur à une seconde valeur déterminée, soit aux bornes de la diode d'une tension correspondant à une valeur de courant de charge d'entretien qui est supérieure à une troisième valeur déterminée, elle-même très inférieure à la seconde valeur déterminée.

2. Module contrôleur d'alimentation, selon la revendication 1, caractérisé en ce qu'il comporte un circuit détecteur dont le premier et le second amplificateurs opérationnels (7, 8) ont des entrées (+,-) reliées au même shunt (9) et sont respectivement actifs le premier lors d'une utilisation de la batterie et l'autre lors d'une charge de la batterie.

3. Module contrôleur d'alimentation, selon la revendication 1, caractérisé en ce que le premier amplificateur opérationnel (7) alimente, via sa sortie, les éléments constitutifs des autres modules de l'ensemble de commande qui sont destinés à être alimentés à partir de la batterie en phase d'utilisation de cette batterie en tant que source.

4. Module contrôleur d'alimentation, selon la revendication 2, caractérisé en ce que le second amplificateur opérationnel (8) alimente, via sa sortie, les éléments constitutifs des autres modules de l'ensemble de commande qui sont destinés à être alimentés à partir de la batterie en phase de charge de cette dernière.

5. Module contrôleur d'alimentation, selon la revendication 1, caractérisé en ce que qu'il comporte un circuit logique d'interface (6) inséré entre les deux amplificateurs opérationnels (7, 8) de son circuit détecteur (5), le circuit interrupteur (4) et un sous-ensemble (3) formé par les autres modules de l'ensemble de commande, ce circuit contrôlant l'alimentation des modules du sous-ensemble actifs au cours des phases de charge et en cours d'utilisation de la batterie, à partir de la batterie et via ces amplificateurs opérationnels (7, 8), ainsi que la commande du circuit interrupteur (4).

6. Module contrôleur d'alimentation pour batterie légère, selon au moins l'une des revendications 1 à 5, caractérisé en ce qu'il comporte au moins un circuit détecteur (5) et éventuellement un circuit interrupteur (4) et/ou un circuit logique d'interface (6) physiquement incorporés dans un conditionnement d'un élément accumulateur destiné à être utilisé seul, ou de l'ensemble des éléments accumulateurs d'une batterie.

7. Batterie d'accumulateur, caractérisée en ce qu'elle contient un module contrôleur d'alimentation selon l'une des revendications 1 à 6, dans le conditionnement qui l'habille elle-même.

## Patentansprüche

1. Speisekontrollmodul für die Kontrolleinheit einer Batterie (1) zur Speisung eines Geräts (2), mit einer Detektorschaltung (5), die einer im Speisekreis des Geräts und der Batterie angeordneten Schalteinheit zugeordnet ist und einen Ableitwiderstand (9) im Speisekreis des Geräts zwischen der Batterie und der Schalteinheit besitzt, wobei dieser Ableitwiderstand mit seinen Klemmen an die Eingänge (+, -) eines ersten Operationsverstärkers (7) angeschlossen ist, der als Komparator geschaltet ist, um wenig Strom zu verbrauchen und als Stromdetektor zu arbeiten, der nur einen Ausgangsstrom liefert, wenn durch den Ableitwiderstand ein Verbrauchsstrom der Batterie oberhalb eines ersten vorbestimmten Werts fließt, dadurch gekennzeichnet, daß die Detektorschaltung außerdem einen zweiten Verstärker (8) aufweist, der als Komparator geschaltet ist, um wenig Strom zu verbrauchen und als Stromdetektor zu wirken, wobei dessen Eingänge (+, -) einerseits an die Klemmen des Ableitwiderstands und andererseits über diesen Widerstand an die Klemmen einer Diode (19) angeschlossen sind, die in Reihe mit einem Eichwiderstand (18) in einem zur Schalteinheit parallelen Zweig liegt, um einen Ausgangsstrom nur dann zu liefern, wenn entweder ein Schnelladestrom für die Batterie im Ableitwiderstand fließt, der auch die Schalteinheit durchfließt und der größer als ein zweiter vorbestimmter Wert ist, oder wenn an den Klemmen der Diode eine Spannung entsprechend einem Erhaltungsladestromwert anliegt, der zwar größer als ein dritter vorbestimmter Wert, aber deutlich kleiner als der zweite vorbestimmte Wert ist.

2. Speisekontrollmodul nach Anspruch 1, dadurch gekennzeichnet, daß er eine Detektorschaltung mit dem ersten und dem zweiten Operationsverstärker (7, 8) enthält, deren Eingänge (+, -) mit demselben Ableitwiderstand (9) verbunden sind und von denen der erste bei der Entladung der Batterie und der zweite beim Laden der Batterie aktiv ist.

3. Speisekontrollmodul nach Anspruch 1, dadurch gekennzeichnet, daß der erste Operationsverstärker (7) über seinen Ausgang die wesentlichen Elemente der anderen Moduln der Steuereinheit speist, die von der Batterie in der Nutzphase der Batterie als Stromquelle gespeist werden sollen.

4. Speisekontrollmodul nach Anspruch 2, dadurch gekennzeichnet, daß der zweite Operationsverstärker (8) über seinen Ausgang die wesentlichen Elemente der anderen Moduln der Steuereinheit speist, die aus der Batterie während der Ladephase der Batterie gespeist werden sollen.

5. Speisekontrollmodul nach Anspruch 1, dadurch gekennzeichnet, daß er eine logische Schnittstellenschaltung (6) zwischen den beiden Operationsverstärkern (7, 8) seiner Detektorschaltung (5), der Schalteinheit (4) und einer Untereinheit (3) aufweist, die von den anderen Moduln der Steuereinheit gebildet wird, wobei diese logische Schaltung die Speisung der Moduln der während der Ladephase bzw. während der Nutzphase der Batterie ausgehend von der Batterie und über die Operationsverstärker (7, 8) kontrolliert, sowie die Schalteinheit (4) steuert.

6. Speisekontrollmodul für eine leichte Batterie gemäß mindestens einem der Ansprüche 1 bis 5, dadurch gekennzeichnet, daß sie mindestens eine Detektorschaltung (5) und ggf. eine Schalteinheit (4) und/oder eine Schnittstellenschaltung (6) enthält, die physisch in ein Gehäuse eines Akkumulatorelements, falls es allein verwendet werden soll, oder in das Gehäuse von einer Gruppe von Akkumulatorelementen einer Batterie inkorporiert sind.

7. Akkumulatorbatterie, dadurch gekennzeichnet, daß sie einen Speisekontrollmodul nach einem der Ansprüche 1 bis 6 in ihrem Gehäuse enthält.

## Claims

1. A power supply control module for a control system for controlling a power supply battery (1) for powering an appliance (2) including a detector circuit (5) associated with a switch circuit (4) placed in the power loop via which the battery powers the appliance, the detector circuit including a shunt resistor (9) inserted between the battery and the switch circuit in the loop via which the appliance is powered, the shunt resistor being connected via its terminals to the inputs (+, -) of a first operational amplifier (7) which is connected as a comparator so as to have low consumption, and which is used as a current detector so as to supply an output current only when in the presence of a battery-in-use current flowing through the shunt resistor that is higher than a first determined value, said power supply control module being characterized in that said detector circuit also includes a second amplifier circuit (8) which is connected as a comparator so as to have low consumption, and which is used as a current detector, the inputs (+, -) of the second operational amplifier being connected to the terminals of the shunt resistor, and, via the shunt resistor, to the terminals of a diode (19) placed in series with a calibration resistor (18) in a branch that is parallel to the switch circuit, the second operational amplifier supplying an output current only when in the presence either of a fast battery-charge current flowing through the shunt resistor and through the switch circuit that is higher than a second determined value, or else of a voltage across the terminals of the diode that corresponds to a trickle charge current that is higher than a third determined value which is in turn much lower than the second determined value.

2. A power supply control module according to claim 1, characterized in that it includes a detector circuit whose first operational amplifier (7) and second operational amplifier have their inputs (+, -) connected to the same shunt resistor (9), the first operational amplifier being active when the battery is in use, and the second operational amplifier being active when the battery is being charged.

3. A power supply control module according to claim 1, characterized in that the first operational amplifier (7) powers, via its output, those constituent parts of the other modules in the control system which are intended to be powered by the battery when the battery is being used as a power source.

4. A power supply control module according to claim 2, characterized in that the second operational amplifier (8) powers, via its output, those constituent parts of the other modules in the control system which are intended to be powered by the battery when the battery is being charged.

5. A power supply control module according to claim 1, characterized in that it includes an interface logic circuit (6) inserted between the two operational amplifiers (7, 8) of its detector circuit (5), the switch circuit (4), and a sub-system (3) formed by the other modules in the control system, the circuit controlling the power supply to the modules in the sub-system that are active either during battery charging or during battery use from the battery and via the operational amplifiers (7, 8), and controlling the switch circuit (4).

6. A power supply control module according to any one of claims 1 to 5 for a lightweight battery, said control module being characterized in that it includes at least a detector circuit (5) and optionally a switch circuit (4) and/or an interface logic circuit (6) that is/are physically incorporated in the pack in which a storage cell designed to be used on its own is packaged, or in the pack in which the set of storage cells of a battery are packaged.

7. A storage cell battery characterized in that it contains a power supply control module according to any one of claims 1 to 6, in the pack in which it is packaged.
